# EUROPEAN PATENT APPLICATION

(11) **EP 4 811 949 A1**
(43) Date of publication of application: **23.09.2026**
(21) Application number: 24890123.3
(22) Date of filing: 27.06.2024
(51) Int. Cl.: H05K 9/00

(54) **ELECTROSTATIC SHIELDING STRUCTURE, WIRELESS CHARGING SYSTEM, AND VEHICLE**

(30) Priority: 15.11.2023 CN 202323082338 U
(71) Applicant: BYD Company Limited, Shenzhen, Guangdong 518118 (CN)
(72) Inventor: WANG, Zhen, Shenzhen, Guangdong 518118 (CN); ZENG, Shuai, Shenzhen, Guangdong 518118 (CN)
(74) Representative: Mathys & Squire
(86) International application number: PCT/CN2024/102023
(87) International publication number: WO 2025/102754

(57) **Abstract**

Provided is a vehicle, including a wireless charging system, where the wireless charging system includes a wireless charging transmitter apparatus, and the wireless charging transmitter apparatus includes an electrostatic shielding structure. The electrostatic shielding structure includes a plurality of conductive sections and a conductive connecting portion, the plurality of conductive sections extend radially and are configured to be in a closed shape with a hollow radial inner side, the plurality of conductive sections are separated from each other by a plurality of first spacings, at least one of the conductive sections is grounded, and the plurality of conductive sections are conductively connected via the conductive connecting portion.

## Description

### CROSS-REFERENCE TO RELATED APPLICATIONS

This application claims priority to Chinese Patent Application No. 202323082338.X, filed on November 15, 2023, and entitled "ELECTROSTATIC SHIELDING STRUCTURE FOR WIRELESS CHARGING AND VEHICLE", which is incorporated herein by reference in its entirety.

### TECHNICAL FIELD

The present disclosure relates to the field of wireless charging, and more specifically, to an electrostatic shielding structure, a wireless charging system, and a vehicle.

### BACKGROUND

In a wireless charging system, a coil apparatus utilizes the principle of electromagnetic induction to achieve contactless power transmission in the form of electromagnetic waves. Because low-frequency electric and magnetic fields are generated around the coil apparatus, electromagnetic radiation is received by other electrical devices, causing electromagnetic interference (EMI). The interference may interrupt, hinder, or otherwise reduce or limit the effective performance of the other electrical devices, causing electromagnetic pollution to an environmental space within a specific range.

Currently, there is limited research on electric field shielding in wireless charging systems. If the electric field around the coil apparatus is not effectively shielded, the shielding performance of the wireless charging systems may be severely affected.

### SUMMARY

To resolve the foregoing problems, embodiments of the present utility model provide an electrostatic shielding structure for wireless charging.

According to a first aspect of the present disclosure, an electrostatic shielding structure is provided. The electrostatic shielding structure includes a plurality of conductive sections and a conductive connecting portion, the plurality of conductive sections extend radially and are configured to be in a closed shape with a hollow radial inner side, the plurality of conductive sections are separated from each other by a plurality of first spacings, at least one of the conductive sections is grounded, and the plurality of conductive sections are conductively connected via the conductive connecting portion.

Optionally, a length of the grounded conductive section is greater than those of other conductive sections, and the grounded conductive section is grounded on a radial outer side.

Optionally, a size of the first spacing is smaller than a width of the conductive section.

Optionally, the plurality of conductive sections and the conductive connecting portion constitute N shielding components, there is a second spacing between the shielding components, there are N grounded conductive sections, and each shielding component includes one of the grounded conductive sections, wherein N is a positive integer greater than or equal to 2.

Optionally, the conductive connecting portion is located on the radial inner side of the plurality of conductive sections; or the conductive connecting portion is located on the radial outer side of the plurality of conductive sections; or the conductive connecting portion is located at a position between the radial inner side and the radial outer side of the plurality of conductive sections.

Optionally, the electrostatic shielding structure is annular, square, racetrack-shaped, or in another shape.

Optionally, the plurality of conductive sections or the conductive connecting portion is made of a material selected from silver, copper, aluminum, gold, tin, and a combination thereof.

According to a second aspect of the present disclosure, a wireless charging system is provided. The wireless charging system includes a wireless charging transmitter apparatus, the wireless charging transmitter apparatus includes a transmitting coil, and the electrostatic shielding structure according to any one in the first aspect of the present disclosure is provided on a top surface of the transmitting coil.

Optionally, the electrostatic shielding structure has the same shape as the transmitting coil, outer diameters of the plurality of conductive sections are greater than or equal to that of the transmitting coil, and inner diameters of the plurality of conductive sections are less than or equal to that of the transmitting coil.

Optionally, the wireless charging system further includes a wireless charging receiver apparatus, the wireless charging receiver apparatus includes a receiving coil, and the electrostatic shielding structure is located on a side of the transmitting coil facing the receiving coil.

According to a third aspect of the present disclosure, a vehicle is provided. The vehicle includes the wireless charging system according to any one of the second aspect of the present disclosure.

The electrostatic shielding structure provided in the embodiments of the present disclosure includes a plurality of conductive sections and a conductive connecting portion, the plurality of conductive sections extend radially and are in a closed shape, the plurality of conductive sections are separated from each other by a plurality of first spacings, at least one of the conductive sections is grounded, and the plurality of conductive sections are conductively connected via the conductive connecting portion. By means of such a structural design, an annular induced electric field generated in the wireless charging system can be effectively shielded, preventing it from leaking into a system environment and avoiding the leaked electric field from adversely affecting other electronic components or the entire system. The electrostatic shielding structure using such structural design has high shielding performance, simple processing technology, and a series of advantages such as small size, light weight, and low costs, and can be safely and widely used in wireless charging systems.

Other features of the embodiments of the present disclosure and advantages thereof become clear from the following detailed description of exemplary embodiments of the present disclosure with reference to accompanying drawings.

### DESCRIPTION OF DRAWINGS

Accompanying drawings, which are incorporated in the specification and constitute a part of the specification, show embodiments of the present disclosure and serve, with their description, to explain principles of the embodiments of the present disclosure.
FIG. 1 shows an axial magnetic field (positive or negative) of a wireless charging system according to an embodiment of the present disclosure;
FIG. 2 shows an annular induced electric field (clockwise or counterclockwise) of a wireless charging system according to an embodiment of the present disclosure;
FIG. 3 shows an annular induced electric field of a shielding component according to an embodiment of the present disclosure;
FIG. 4 shows a circular electrostatic shielding structure of a wireless charging system according to an embodiment of the present disclosure;
FIG. 5 shows a square electrostatic shielding structure of a wireless charging system according to an embodiment of the present disclosure;
FIG. 6 shows a racetrack-shaped electrostatic shielding structure of a wireless charging system according to an embodiment of the present disclosure;
FIG. 7 shows an electrostatic shielding structure with sectioned connection at an inner-diameter position of a wireless charging system according to an embodiment of the present disclosure; and
FIG. 8 shows an electrostatic shielding structure with sectioned connection at an outer-diameter position of a wireless charging system according to an embodiment of the present disclosure.

### Reference numerals:

10: shielding component; 11: first conductive section; 12: second conductive section; 13: conductive connecting portion.

### DESCRIPTION OF EMBODIMENTS

Embodiments of the present disclosure are described in detail below, examples of which are shown in accompanying drawings, where same or similar reference numerals throughout represent same or similar elements or elements having same or similar functions. The embodiments described below with reference to the accompanying drawings are exemplary and are merely used to explain the present disclosure, and will not be construed as a limitation on the present disclosure. All other embodiments obtained by a person of ordinary skill in the art based on the embodiments in the present disclosure without creative efforts shall fall within the scope of protection of the present disclosure.

In the specification and claims of the present disclosure, features defined by the terms "first" and "second" may explicitly or implicitly include one or more features. In the description of the present disclosure, unless otherwise stated, "a plurality of" means two or more.

In the description of the present disclosure, it will be understood that an orientation or a position relationship indicated by the term "center", "length", "width", "thickness", "upper", "lower", "front", "rear", "left", "right", "vertical", "horizontal", "top", "bottom", "inside", "outside", "clockwise", "counterclockwise", "axial", "radial", "circumferential", or the like is an orientation or a position relationship shown in the accompanying drawings, and is merely intended to facilitate describing the present disclosure and simplify the description, but is not intended to indicate or imply that an apparatus or element in question must have a specific orientation and must be constructed and operated in a specific orientation. Therefore, such a term cannot be construed as a limitation on the present disclosure.

For an entire wireless charging system, in addition to the coil transmission efficiency and system stability, the electromagnetic environment safety of the wireless charging system during operation needs further improvement. Currently, most wireless charging systems lack shielding against an electric field, and the influence of the electric field during system operation is also non-negligible.

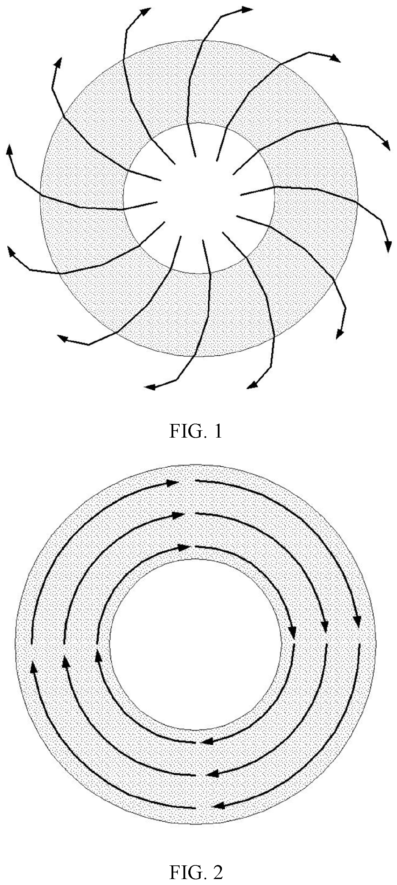

During operation of the wireless charging system, an axial annular magnetic field is generated. Taking an annular transmitting coil and an annular receiving coil as an example, as shown in FIG. 1, magnetic induction lines start from the middle of the transmitting coil, point to an outer edge of the transmitting coil, enter via an outer edge of the receiving coil, come out from the middle of the receiving coil, and return to the middle of the transmitting coil again, thus forming the axial annular magnetic field.

The magnetic field can induce an electric field, and a direction of the magnetic field can determine a direction of the electric field. According to the right-hand rule, a corresponding annular induced electric field is formed in a top view direction of the transmitting coil or receiving coil, and as shown in FIG. 2, the direction of the annular induced electric field may be clockwise or counterclockwise.

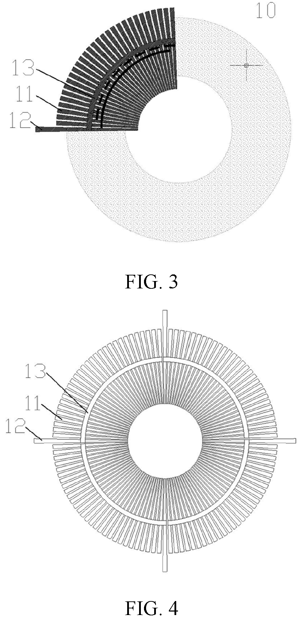

According to one embodiment of the present disclosure, an electrostatic shielding structure is provided, and as shown in FIG. 3, the electrostatic shielding structure includes a plurality of conductive sections and a conductive connecting portion 13; and the plurality of conductive sections extend radially and are configured to be in a closed shape with a hollow radial inner side, the plurality of conductive sections are separated from each other by a plurality of first spacings, at least one conductive section is grounded, and the plurality of conductive sections are conductively connected via the conductive connecting portion 13. To facilitate differentiation of a grounded conductive section, the plurality of conductive sections are divided into first conductive sections 11 and a grounded second conductive section 12.

By means of such a structural design, because the electrostatic shielding structure is embedded in a wireless charging power generation apparatus, the electrostatic shielding structure is provided to directly cover a transmitting coil and exceed physical or geometric dimensions of the transmitting coil. To operate properly, the electrostatic shielding structure has to be grounded. Grounded shielding can terminate an electric field generated by switching of a charging current carried by the transmitting coil of a wireless charging system. Meanwhile, at each point on the electrostatic shielding structure, the annular induced electric field may have a direction that is substantially perpendicular to at least one conductive section of the first conductive sections 11 and the second conductive section 12. The electrostatic shielding structure can effectively shield the annular induced electric field generated in the wireless charging system by utilizing the principle of electric field induction, preventing an electric field around a coil apparatus from leaking into a system environment and avoiding the leaked electric field from adversely affecting other electronic components or the entire system. Meanwhile, magnetic field energy is still allowed to radiate in an area above the shielding component, so that the wireless charging system can still charge a load inductively coupled to the transmitting coil, thereby effectively resolving problems such as electromagnetic interference (EMI) in the wireless charging system.

In one embodiment, a length of the second conductive section 12 is greater than those of the first conductive sections 11, and a radial outer side of the second conductive section 12 is grounded; as shown in FIG. 3, the second conductive section 12 is located on one side of the plurality of first conductive sections 11 in a circumferential direction; the second conductive section 12 has an extension end, and the second conductive section 12 is grounded at the extension end; and the position of the second conductive section 12 relative to the plurality of first conductive sections 11 is not limited, and the second conductive section 12 may also be located in the middle of the plurality of first conductive sections 11.

In one embodiment, a size of the first spacing is smaller than both a width of the first conductive section 11 and a width of the second conductive section 12.

In one embodiment, the plurality of conductive sections and conductive connecting portion constitute N shielding components 10, there is a second spacing between the shielding components 10, there are N second conductive sections 12, and each shielding component includes one second conductive section 12, where N is a positive integer greater than or equal to 2. Taking N being 4 as an example, a circular electrostatic shielding structure can comprise four shielding components 10 with a same structure and size, and the four shielding components 10 are separated from each other and not connected. Because a magnetic field generated by a planar spiral coil is stronger at an inner circular edge of the transmitting coil/receiving coil, weakens toward a middle portion, and further increases at an outer circuit edge of the transmitting coil/receiving coil, each shielding component 10 can effectively isolate and shield, at a smaller end surface on the radial inner side, a strong interference electric field at the inner circular edge of a magnetically coupled coil; a plurality of adjacent shielding components 10 can better neutralize and cancel the induced electric field; and meanwhile, the spaced shielding components 10 can interrupt an induced eddy current ring, thereby greatly reducing an electric field strength value of the interference field in a protected space. A number of shielding components 10 can also be two, six, or more, and the electrostatic shielding structure comprises two, six, or more shielding components spaced apart from each other.

In one embodiment, the conductive connecting portion 13 is located at a position between the radial inner side and the radial outer side of the first conductive sections 11, as shown in FIG. 4 to FIG. 6. On the basis of distribution characteristics of the induced magnetic field in wireless transmission, a weaker area in the magnetic field between the radial inner side and radial outer side of the shielding component 10 is connected via the conductive connecting portion, and the radial outer end of the second conductive section 12 is grounded, so that generation of an annular induced electric field and an induced magnetic field eddy current can be effectively avoided, thereby effectively avoiding noise accumulation, electronic interference, and eddy current heat loss.

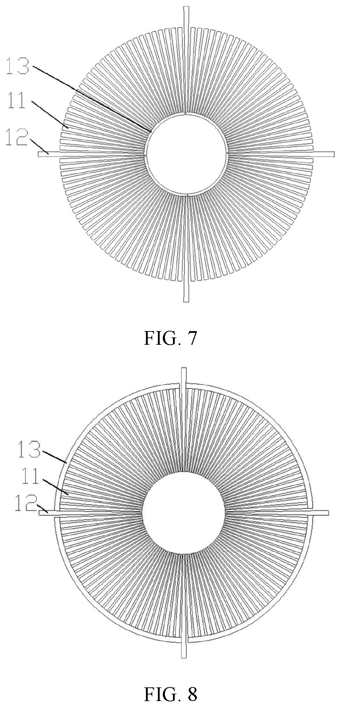

There are a plurality of other arrangement positions for the conductive connecting portion 13. For example, the conductive connecting portion 13 may be located on the radial inner side of the first conductive sections 11, as shown in FIG. 7. For example, the conductive connecting portion 13 is located on the radial outer side of the first conductive sections 11, as shown in FIG. 8.

In one embodiment, the electrostatic shielding structure is annular, square, racetrack-shaped, or in other shapes. The shape of the electrostatic shielding structure can be designed and adjusted on the basis of that of the magnetically coupled coil.

In one embodiment, the first conductive section 11, the second conductive section 12, or the conductive connecting portion 13 may be made of a material selected from metals with higher conductivity, such as silver, copper, aluminum, gold, and tin, or alloys, so that the electrostatic shielding structure can effectively shield stray electromagnetic fields and provide thermal shielding. The electrostatic shielding structure can be a single metallic structural shielding layer, an etched side of a printed circuit board, or a flexible carrier with a conductive coating. In this way, the electrostatic shielding structure has high shielding performance, simple processing technology, and advantages such as small size, light weight, and low costs.

In one embodiment, the thickness of the shielding component 10 should be as small as possible, preferably on the order of micrometers. A thinner conductive material allows a magnetic flux to pass through, but prevents an electric field from passing through, effectively avoiding generation of larger eddy current loss on the shielding component during magnetic field coupling of the wireless charging system.

In addition, the embodiments of the present disclosure further provide a wireless charging transmitter apparatus. The wireless charging transmitter apparatus includes a transmitting coil, and the electrostatic shielding structure according to any one of the foregoing embodiments is provided on a top surface of the transmitting coil.

In one embodiment, the electrostatic shielding structure has a same shape as the transmitting coil, outer diameters of the first conductive sections are greater than or equal to that of the transmitting coil, and inner diameters of the first conductive sections are less than or equal to that of the transmitting coil.

The entire electrostatic shielding structure may be similar in shape to the transmitting coil, with an outer diameter slightly larger than that of the transmitting coil and an inner diameter slightly smaller than that of the transmitting coil, so that the entire electrostatic shielding structure fully covers the transmitting coil. If a large number of conductive sections are arranged at hollowed-out positions on the radial outer side and the radial inner side of the transmitting coil, the generation of an annular eddy current increases, which is not conducive to wireless power transmission and will also lead to an increase in processing and manufacturing costs.

Furthermore, the embodiments of the present disclosure further provide a wireless charging system. The wireless charging system includes the wireless charging transmitter apparatus according to any one of the foregoing embodiments.

In one embodiment, the wireless charging system further includes a wireless charging receiver apparatus, the wireless charging receiver apparatus includes a receiving coil, and the electrostatic shielding structure is located on a side of the transmitting coil facing the receiving coil.

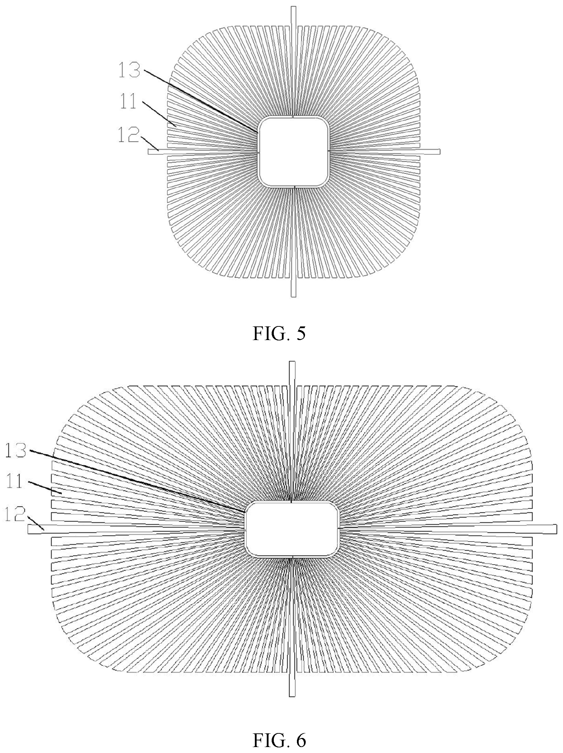

The structural types of the transmitting coil and the receiving coil can be designed on the basis of a Qi standard, a Power Matters Alliance (PMA) standard, an Alliance for Wireless Power (A4WP) standard, or other wireless charging standards. The corresponding electrostatic shielding structure can be designed into a circular or square structure similar to a single magnetically coupled coil, as shown in FIG. 4, FIG. 5, FIG. 7, and FIG. 8, or a long racetrack-shaped structure comprising three magnetically coupled coils, as shown in FIG. 6, or various structural types corresponding to a specific shape of a wireless power transmission coil.

In addition, the embodiments of the present disclosure further provide a vehicle. The vehicle includes the wireless charging system according to any one of the foregoing embodiments, and for a specific implementation thereof, reference may be made to the foregoing embodiments.

By means of such a structural design, the annular induced electric field generated in the wireless charging system can be effectively shielded, preventing same from being coupled to other electronic modules or antennas in the vehicle and avoiding the leaked electric field from adversely affecting other electronic components or the entire system; and meanwhile, magnetic field energy is still allowed to radiate in an area between wireless charging modules. The electrostatic shielding structure using such structural design has high shielding performance, simple processing technology, and a series of advantages such as small size, light weight, and low costs, and can be safely and widely used in wireless charging systems for a vehicle, a mobile terminal, and the like.

Specific embodiments of the present disclosure are described above. The other embodiments fall within the scope of the appended claims. In some cases, the actions or steps recited in the claims may be performed in a sequence different from that in the embodiments, and may still achieve desired results. In addition, the processes depicted in the accompanying drawings do not necessarily require a specific or consecutive sequence shown to achieve the desired results. In some implementations, multitasking and parallel processing are also possible or may be advantageous.

The foregoing has described the embodiments of the present disclosure. The foregoing description is exemplary, not exhaustive, and is not limited to the disclosed embodiments. Many modifications and changes are clear to a person of ordinary skill in the art without departing from the scope of the illustrated embodiments. Selection of terms used herein is intended to best explain principles and actual applications of the embodiments or technical improvements on technologies in the market, or to enable another person of ordinary skill in the art to understand the embodiments disclosed herein.

## Claims

1. An electrostatic shielding structure, comprising: a plurality of conductive sections (11, 12) and a conductive connecting portion (13), wherein
the plurality of conductive sections (11, 12) extend radially and are configured to be in a closed shape with a hollow radial inner side, the plurality of conductive sections (11, 12) are separated from each other by a plurality of first spacings, at least one of the conductive sections is grounded, and the plurality of conductive sections (11, 12) are conductively connected via the conductive connecting portion (13).

2. The electrostatic shielding structure according to claim 1, wherein a length of the grounded conductive section is greater than those of other conductive sections, and the grounded conductive section is grounded on a radial outer side.

3. The electrostatic shielding structure according to claim 2, wherein a size of the first spacing is smaller than a width of the conductive section.

4. The electrostatic shielding structure according to claim 2, wherein
the plurality of conductive sections (11, 12) and the conductive connecting portion (13) constitute N shielding components, there is a second spacing between the shielding components, there are N grounded conductive sections, and each shielding component comprises one of the grounded conductive sections, wherein N is a positive integer greater than or equal to 2.

5. The electrostatic shielding structure according to any one of claims 1 to 4, wherein the conductive connecting portion (13) is located on the radial inner side of the plurality of conductive sections (11, 12); or
the conductive connecting portion (13) is located on the radial outer side of the plurality of conductive sections (11, 12); or
the conductive connecting portion (13) is located at a position between the radial inner side and the radial outer side of the plurality of conductive sections (11, 12).

6. The electrostatic shielding structure according to any one of claims 1 to 5, wherein the electrostatic shielding structure is annular, square, racetrack-shaped, or in another shape.

7. The electrostatic shielding structure according to any one of claims 1 to 6, wherein the plurality of conductive sections (11, 12) or the conductive connecting portion (13) is made of a material selected from silver, copper, aluminum, gold, tin, and a combination thereof.

8. A wireless charging system, comprising a wireless charging transmitter apparatus, wherein the wireless charging transmitter apparatus comprises a transmitting coil, and the electrostatic shielding structure according to any one of claims 1 to 7 is provided on a top surface of the transmitting coil.

9. The wireless charging system according to claim 8, wherein the electrostatic shielding structure has a same shape as the transmitting coil, outer diameters of the plurality of conductive sections (11, 12) are greater than or equal to outer diameters of the transmitting coil, and inner diameters of the plurality of conductive sections (11, 12) are less than or equal to inner diameters of the transmitting coil.

10. The wireless charging system according to claim 8, further comprising a wireless charging receiver apparatus, wherein the wireless charging receiver apparatus comprises a receiving coil, and the electrostatic shielding structure is located on a side of the transmitting coil facing the receiving coil.

11. A vehicle, comprising the wireless charging system according to any one of claims 8 to 10.
